Europäisches Patentamt

European Patent Office

Office européen des brevets

(19)

(11) Veröffentlichungsnummer: **0 067 269**

A1

(12) **EUROPÄISCHE PATENTANMELDUNG**

(21) Anmeldenummer: 82100588.1

(22) Anmeldetag: 28.01.82

(51) Int. Cl.³: **H 03 F 3/387**

(30) Priorität: 12.06.81 DE 3123272

(43) Veröffentlichungstag der Anmeldung:
22.12.82 Patentblatt 82/51

(84) Benannte Vertragsstaaten:
CH DE FR GB IT LI

(71) Anmelder: ROBERT BOSCH GMBH
Postfach 50
D-7000 Stuttgart 1(DE)

(72) Erfinder: Fiebig, Arnim, Ing.grad.
Oberer Hellrain 10
D-6120 Erbach/Odenwald(DE)

(74) Vertreter: Uhlig, Helge, Ing.-Grad.
ROBERT BOSCH GMBH Geschäftsbereich
Industrieausrüstung Patente und Lizenzen Postfach 11
49
D-6120 Erbach/Odenwald(DE)

(54) Trennübertrager für Gleich- und Wechselspannungen.

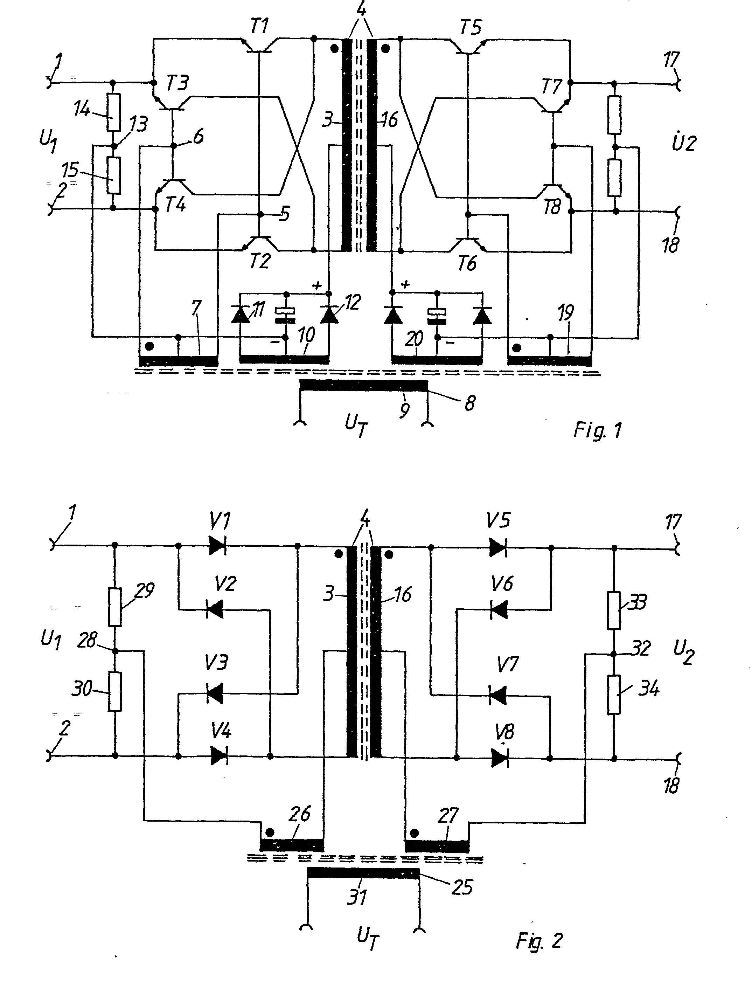

(57) Eine potentialfreie Übertragung von Gleich- und Wechselspannungen wird mit einfachen elektronischen Bauelementen möglich, die nach Art eines Ringmodulators geschaltet, eine Eingangsspannung taktweise umgeschaltet an die Primärwicklung (3) eines Übertragers (4) legen, über den die Potentialtrennung erfolgt. Die auf eine Sekundärwicklung (16) dieses Übertragers übertragene umgetaktete Spannung wird dann in einer gleichartig geschalteten Ausgangsschaltung, mit der gleichen Taktspannung, ein zweites Mal in der Weise taktweise umgeschaltet, daß die erste Umschaltung wieder rückgängig gemacht wird und so eine der Eingangsspannung entsprechende Ausgangsspannung entsteht (siehe Fig. 2).

Fig. 2

EP 0 067 269 A1

IA-Er/78

lo. 6. 1981/HU/mw


ROBERT BOSCH GMBH, 7000 Stuttgart 1


Trennübertrager für Gleich- und Wechselspannungen


.Stand der Technik

Bei der Übertragung von Spannungen wird in vielen Fällen eine Potentialtrennung erforderlich, die sich bei Wechselspannungen, insbesondere sinusförmigen Wechselspannungen, sehr einfach mit einem Übertrager verwirklichen läßt, der getrennte Primär- und Sekundärwicklungen aufweist. Zur Übertragung von Gleichspannungen oder Impulsen sind Koppelglieder wie z.B. Optokoppler bekannt, die gleichfalls ohne großen Aufwand eine Potentialtrennung ermöglichen. Sollen jedoch sowohl Gleich- wie Wechselspannungen wie z.B. eine, einem Analogwert entsprechende Spannung mit wechselnder Polarität, übertragen werden, wird ein verhältnismäßig großer Aufwand erforderlich um eine potentialfreie Übertragung zu ermöglichen. So kann der Analogwert über Analog-Digitalwandler in einen Digitalwert umgesetzt, dieser potentialfrei übertragen und danach mit einem Digital-Analogwandler zurückgewandelt werden. Häufig erhöht sich hierbei der Aufwand, da bei einer Verwendung von aktiven Bauelementen Versorgungsspannungen erforderlich werden, die dann gleichfalls einer Potential-trennung bedürfen.

IA-Er/78

Weiterhin ist es bekannt (siehe z.B. DT-AS 1 244 242), die zu übertragende Spannung zu takten und je nach Polarität über zwei getrennte Obertrager mit getrennten Sekundärwicklungen zu übertragen, danach gleichzurichten und polaritätsgerecht wieder auf einen Ausgang zu geben. Diese Schaltung eignet sich gut zur potentialfreien Obertragung von Impulsen unterschiedlicher Polarität, jedoch läßt sich eine lineare Abhängigkeit der Ausgangsspannung zur Eingangsspannung nur durch zusätzlichen erheblichen Mehraufwand erzielen.

Vorteile der Erfindung

Der erfindungsgemäße Trennübertrager mit den in den Ansprüchen gekennzeichneten Merkmalen ermöglicht eine potentialfreie Obertragung der Eingangsspannung mit gleicher Kurvenform, Polarität und Phasenlage, wobei nur wenige Bauelemente erforderlich werden. In Weiterbildung der Erfindung wird eine Potentialtrennung zwischen Eingang und Ausgang möglich, die eine hohe Durchschlagsfestigkeit aufweist. Der Trennübertrager kann hierbei derart aufgebaut werden, daß keine zusätzliche potentialgetrennte Versorgungsspannung erforderlich ist und als kleiner, robuster, insbesondere vergossener Baustein ausgebildet werden, der sich sehr gut zur potentialfreien Obertragung von Strommeßwerten bei Servomotoren eignet, die über elektronische Regelkreise verfügen.

Zeichnungen

Ausführungsbeispiele der Erfindung sind in drei Zeichnungsblättern dargestellt und in der nachfolgenden Beschreibung näher erläutert. Es zeigen

Fig. 1 die Schaltung eines Trennverstärkers mit Transistoren,
Fig. 2 einen Trennverstärker ohne aktive Bauelemente
Fig. 3 Spannungsverläufe an einzelnen Punkten des Trennverstärkers
Fig. 4 ein Anwendungsbeispiel des Trennverstärkers bei Servomotoren und
Fig. 5 den Aufbau eines erfindungsgemäßen Trennverstärkers mit hoher Durchschlagsfestigkeit.

IA-Er/78

In Fig. 1 sind die beiden Eingangsklemmen 1, 2 des Trennverstärkers mit je zwei Emitter von vier Transistoren T 1 bis T 4 verbunden, deren Kollektoren an der Primärwicklung 3 eines Obertragers 4 liegen. Diese Verbindung ist derart gewählt, daß jeweils der Kollektor eines ersten der beiden Transistoren T 1 oder T 3 bzw. T 2 oder T 4 - deren Ermitter an der gleichen Eingangsklemme 1 oder 2 liegen - mit dem einen Ende der Primärwicklung 3 verbunden sind und jeweils der Kollektor des zweiten Transistors am anderen Ende der Primärwicklung angeschlossen ist. Die Basis der Transistoren T 1 und T 3,deren Ermitter an der Eingangs- klemme 1 liegen,ist jeweils mit der Basis eines Transistors T 2 bzw. T 3 verbunden, deren Ermitter an der anderen Eingangsklemme 2 liegen, wobei jeweils die Basisverbindung 5 und 6 zwischen den Transistoren gewählt ist, deren Ermitter an unterschiedlichen Enden der Primärwicklung 3 liegen. Die beiden Basisverbindungen 5 und 6 sind an den Enden einer Sekundärwicklung 7 eines weiteren Obertragers 8 angeschlossen, der magnetisch getrennt vom Obertrager 4 angeordnet ist. Der Primärwicklung 9 dieses Obertragers 8 wird eine Taktspannung $U_T$ zugeführt, die über eine weitere Sekundärwicklung 10 mit Mittelabgriff in bekannter Weise in einer Zweiweggleichrichtung mit zwei Dioden 11, 12 gleichgerichtet wird. Die gleichgerichtete Taktspannung dient als potentialfreie Versorgungsspannung, wobei deren positiver Anschluß an einem Mittelabgriff der Primärwicklung 3 des Obertragers 4 liegt und deren negativer Anschluß an einen Mittelabgriff der Sekundärwicklung 7 des Taktübertragers 8 und dem Verbindungspunkt 13 von zwei Widerständen 14, 15 angeschlossen ist, deren andere Enden mit den Eingangsklemmen 1, 2 verbunden sind. Dieser Eingangsschaltung ist eine spiegelbildlich in gleicher Weise geschaltete Ausgangsschaltung zugeordnet, wobei eine Sekundärwicklung 16 des Obertragers 4 spiegelbildlich mit der Primärwicklung über vier weitere Transistoren T 5 bis T 8 mit den Ausgangsklemmen 17, 18 des Trennübertragers verbunden ist. Weiterhin sind auf den Taktübertrager 8 gleichfalls spiegelbildlich zur Eingangsschaltung geschaltete weitere Sekundärwicklungen 19, 20 vorgesehen, wobei die Enden der Sekundärwicklung 19 an den Basisverbindungen 21, 22 liegen und die Sekundwärwicklung 20

IA-Er/78

mit einer weiteren Gleichrichterschaltung der potentialfreien Stromversorgung der Transistoren T 5 bis T 8 dient. Die Transistoren T 1 bis T 4
wirken hierbei wie Schalter, welche durch die - den Basisverbindungen 5, 6
mit entgegengesetzter Polarität zugeführte - Taktspannung 4 abwechselnd
in einer Weise geöffnet oder geschlossen werden, daß die an den Eingangsklemmen anliegende Eingangsspannung Takt für Takt umgepolt an die Enden
der Primärwicklung 3 des Obertragers 4 gelegt werden. In gleicher Weise
wirkt die Ausgangsschaltung, wobei die an den Enden der Sekundärwicklung
16 des Obertragers anliegende Spannung Takt für Takt umgepolt an die
Ausgangsklemmen 17, 18 des Trennübertragers gelangt.

Anstelle der Transistoren T 1 bis T 8 können Feldeffekttransistoren oder
mit diesen aufgebaute Analogschalter Verwendung finden, wobei - falls keine
zu hohen Anforderungen an die Potentialtrennung gestellt wird - eine gemeinsame hochohmig gesteuerte Taktung ohne Taktübertrager erfolgen kann.

In Fig. 2 ist ein Trennübertrager ohne aktive Bauelemente dargestellt,
wobei anstelle der Transistoren Dioden D1 bis D8 verwendet sind. Hier
liegt die Eingangsklemme 1 an der Anode einer Diode V1 und die Kathode
einer zweiten Diode V2. Die andere Eingangsklemme 2 ist an die Anode einer
dritten Diode V3 und die Kathode einer vierten Diode V4 geführt. Die
Kathode der Diode V1 liegt zusammen mit der Anode der Diode V3 an einem
Ende der Primärwicklung 3 des Obertragers 4, während die Kathode der Diode
V4 zusammen mit der Anode der Diode V2 am anderen Ende der Primärwicklung
3 des Obertragers 4 angeschlossen ist. Der Taktübertrager 25 weist nur
noch zwei Sekundärwicklungen 26, 27 auf, wobei das eine Ende der Sekundärwicklung 26 am Verbindungspunkt 28 zweier Widerstände 29, 30 liegt, deren
andere Anschlüsse mit den Einangsklemmen 1, 2 des Trennübertragers verbunden sind. Das zweite Ende der Sekundärwicklung 26 liegt am Mittelabgriff
der Primärwicklung 3 des Obertragers 4. Auch hier ist die Ausgangsschaltung
in gleicher Weise wie die Eingangsschaltung geschaltet, wobei das eine
Ende der Sekundärwicklung 16 des Obertragers 4 über die Anoden-Kathodenstrecke einer Diode V5 und die Kathoden-Anodenstrecke einer weiteren Diode V7

IA-Er/78

an ·den Ausgangsklemmen 17, 18 des Trennübertragers liegt. Das andere
Ende dieser Sekundärwicklung 16 ist über die Anoden-Kathodenstrecke
einer Diode V8 und die Kathoden-Anodenstrecke einer weiteren Diode V6
gleichfalls mit diesen Ausgangsklemmen 17, 18 verbunden. Die zweite
Sekundärwicklung 27 des Taktübertragers mit einer getrennten Primärwicklung 31 liegt am Mittelabgriff der Sekundärwicklung 16 des Obertragers
4 und mit dem anderen Ende am Verbindungspunkt 32 zweier Widerstände
33, 34, die mit ihren anderen Anschlüssen an den Ausgangsklemmen 17, 18
liegen.

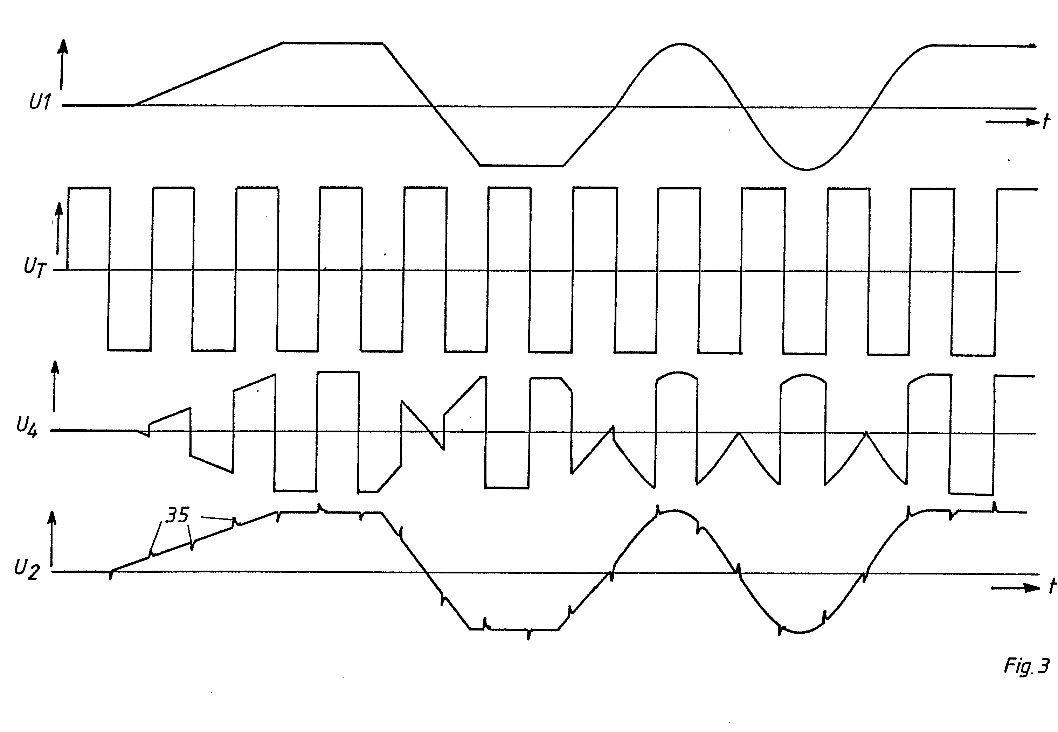

Die Wirkungsweise der Schaltungen gemäß Fig. 1 und 2 wird anhand der
Spannungsverläufe gemäß Fig. 3 näher erläutert. Die an den Eingangsklemmen 1, 2 anliegende Eingangsspannung $U_1$ wird, mit Hilfe der Taktspannung $U_T$ niederohmig einmal direkt und einmal ungepolt, an die Enden
der Primärwicklung 3 gelegt. Dies erfolgt bei der Schaltung gemäß Fig. 1
dadurch, daß den Basisverbindungen 5 und 6 Rechteckimpulse unterschiedlicher Polarität zugeführt werden. Durch positive Taktimpulse an der
Basisverbindung 5 wird die Ermitter-Kollektorstrecke der Transistoren
T 1 und T 2 niederohmig, während gleichzeitig die Ermitter-Kollektorstrecken der Transistoren T 3 und T 4 durch einen negativen Taktimpuls
hochohmig getaktet werden. Springt die Taktspannung $U_T$ um, werden die
Ermitter-Kollektorstrecken der Transistoren T 3 und T 4 niederohmig,
während die Transistoren T 1 und T 2 sperren. Hierdurch werden die Eingangsklemmen 1, 2 niederohmig mit den anderen Enden der Primärwicklung 3
verbunden.

Unter der Voraussetzung, daß die Eingangsspannung U1 die Flußspannungen
der beiden jeweils gleichpolig in Reihe über den Eingangsklemmen 1, 2
liegenden Dioden V1, V3 bzw. V4, V2 in Fig. 2 nicht überschreitet (bei
Siliziumdioden $U1_{max}$ = 1,4 V), wird eine gleichwertige Umtaktung auch mit
Dioden möglich. Die Diodeneingangsschaltung entspricht der bekannten
Schaltung eines Ringmodulators wobei jedoch die Eingangsspannung galvanisch mit den Eingangsklemmen verbunden ist und anstelle der zweiten

IA-Er/78

Wechselspannung eine Taktspannung mit rechteckförmigen Taktimpulsen mit überhöhter Spannung gewählt ist (z.B. 3V). Durch diese Taktspannung werden einmal die Dioden V1 und V4 in den Durchlassbereich und die Dioden V2 und V3 in den Sperrbereich getaktet und nach Umpolung der Taktimpulse die Dioden V1 und V4 in den Sperrbereich gleichzeitig die Dioden V2 und V3 in den Durchlassbereich getaktet. Sowohl bei einer Schaltung nach Fig. 1 wie nach Fig. 2 liegt hierdurch an der Primärwicklung 3 des Obertragers 4 eine Spannung U4 gemäß Fig. 3

Der Obertrager 4 ist derart gewählt, daß er stets unterhalb einer magnetischen Sättigung arbeitet und z.B. als Ringkernübertrager mit ferromagnetischem Kern ausgebildet ist. Bei richtiger Wahl des Wicklungssinnes der Sekundärwicklung 16 bzw. 19, 27 erfolgt in der Ausgangsschaltung eine gleichartige Umtaktung des übertragenen Signals in einer Weise, die an den Ausgangsklemmen 17, 18 eine Spannung U2 entstehen läßt, bei welcher die getaktete Umpolung wieder rückgängig gemacht ist. Werden ausreichend gut gepaarte Transistoren bzw. Dioden verwendet und die Kapazitäten, insbesondere die Leistungskapazitäten klein gehalten, entsteht an den Ausgangsklemmen eine Spannung U2, die bei einem Obersetzungsverhältnis des Obertragers mit 1 : 1, abgesehen von einer geringfügigen linearen Verringerung der Amplitude, weitgehend der Eingangsspannung U1 entspricht. Kleinere der Ausgangsspannung überlagerte Störimpulse 35, die durch die Umtaktung hervorgerufen werden, lassen sich bei entsprechender Wahl der Taktfrequenz und deren Impulsflanken leicht durch nachfolgende Siebglieder unterdrücken, falls diese sich störend auswirken können. Die Wahl der Taktfrequenz, wie auch kleinere Frequenzänderungen sind unkritisch, jedoch sollte die Frequenz den verwendeten Obertragern angepaßt sein und derart gewählt werden, daß sie außerhalb der zu erwartenden bzw. möglichen Frequenz der Eingangsspannung U1 liegen, um Schwebungen zu vermeiden.

IA-Er/78

Wird eine Spannungsübertragung mit größeren Amplituden als die doppelte Flußspannung der Dioden V1 bis V8 erforderlich, ist es möglich, jeweils zwei oder mehr Dioden in Reihe zu schalten und die Amplitude der Taktimpulse entsprechend zu erhöhen. Weiterhin ist es möglich, das Obertragungsverhältnis des Obertragers 4 dem Verwendungszweck anzupassen, wobei z.B. die Spannungsverluste im Trennübertrager ausgeglichen werden können.

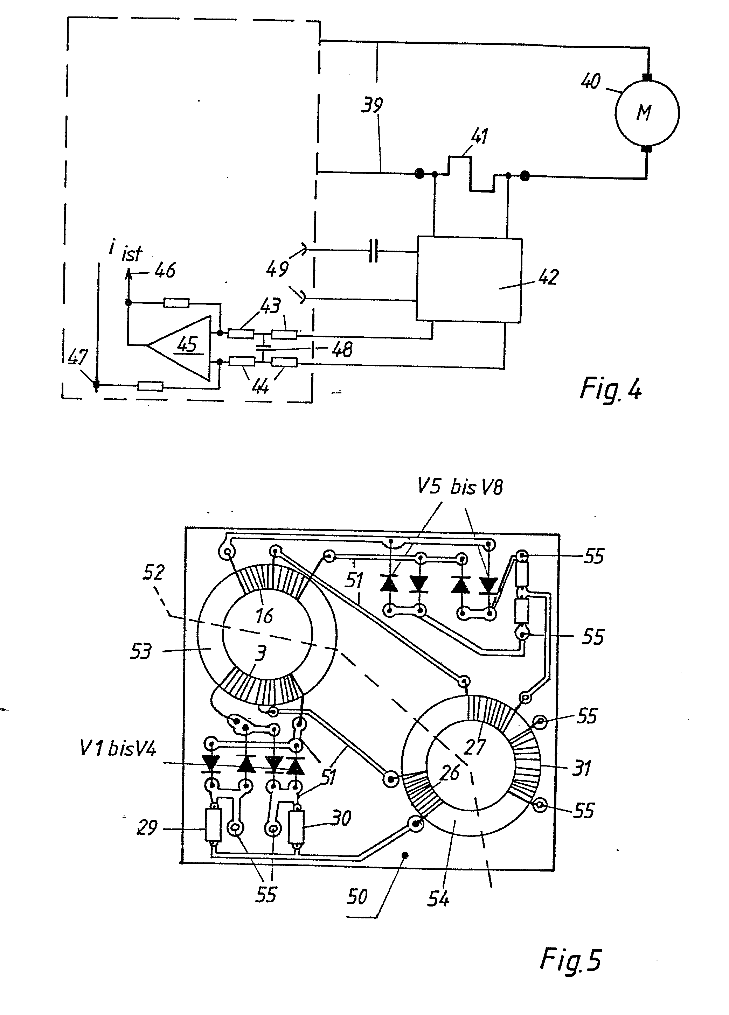

Ein besonders günstiges Anwendungsbeispiel ist in Fig. 4 dargestellt. Müssen Meßwerte von z.B. direkt mit dem Netz verbundenen Zuleitungen 39 für einen Antriebsmotor 40 in eine elektronische Schaltung z.B. zum Regeln des Antriebsmotors 40 eingebracht werden, ist es häufig erforderlich, eine galvanische Trennung zu diesen Hauptstromkreisen durchzuführen, wobei diese Trennung eine Durchschlagsfestigkeit von mehreren tausend Volt standhalten muß. Liegt in der Zuleitung 39 zu einem Motor 40 ein Strommeßwiderstand 41, kann an diesem - mit einfachen Mitteln - eine dem Stromistwert proportionale Spannung abgegriffen werden, wie dies z.B. bei Servomotoren erforderlich wird, bei denen ein Strom-Soll-Istwert-Vergleich erfolgt. Diese am Meßwiderstand 41 anliegende Meßspannung wird nun dem Eingang eines erfindungsgemäßen Trennübertragers 42 zugeführt, dessen Ausgang über jeweils zwei in Reihe liegender Sieb- und Eingangswiderstände 43, 44 an den Eingängen eines in bekannter Weise als Differenzverstärker geschalteten Operationsverstärkers 45 liegt, an dessen Ausgang 46 in bekannter Weise eine, zu einem Pegel (47) proportionale Stromistwertspannung abgegriffen wird. Die Verbindungspunkte der in Reihe liegenden Widerstände 43, 44 sind durch einen Siebkondensator 48 überbrückt, der die - durch die Taktung entstehenden - Störspannungsspitzen unterdrückt. Die Taktung des Trennübertragers kann mit Hilfe eines, in der elektronischen Steuerung schon vorhandenen Taktsignals oder durch eine dort mit einfachen Mitteln erzeugten Taktsignalspannung erfolgen, welche dem Takteingang 49 des Trennübertragers zugeführt wird.

IA-Er/78

Um eine ausreichend hohe Durchschlagsfestigkeit zu erreichen, kann der Trennübertrager auf einer kleinen getrennten Schaltungsplatine 50 mit gedruckten Leiterbahnen 51 gemäß Fig. 5 aufgebaut sein, dem eine Schaltung gemäß Fig. 2 zugrunde liegt. Die einzelnen Bauelemente sind dort mit den gleichen Bezugszeichen versehen. Die Eingangsschaltung ist hier derart angeordnet, daß sich ein verhältnismäßig großer Abstand zu den Bauelementen der Ausgangsschaltung und der Primärwicklung 31 des Takübertragers längs einer Trennlinie 52 ergibt. Die Ferritringkerne 53, 54 können mit einer zusätzlichen Isolationsschicht versehen sein, die ein Durchschlagen innerhalb und am Umfang der Kerne verhindert. Die Platine mit den Bauelementen kann dann in bekannter Weise mit einer durchschlagsfesten Isolationsmasse vergossen sein, aus der nur noch die erforderlichen, über Stifte 55 herausgeführten, Anschlüsse herausragen.

Der erfindungsgemäße mit einfachen Mitteln aufzubauende Trennverstärker läßt eine Taktung mit hohen Frequenzen zu und ermöglicht eine momentanwertgenaue Übertragung auch von Wechselstromanteilen hoher Frequenz wie sie z.B. bei frequenzgesteuerten Drehstrom- oder Synchronmotoren bei einer Stromistwertmessung anfallen können.
Werden mehrere Trennübertrager in einer Anlage erforderlich, können alle mit der gleichen Taktspannung getaktet werden.

IA-Er/78
lo. 6. 1981/HU/mw

ROBERT BOSCH GMBH, 7000 Stuttgart 1

Patentansprüche

1. Trennübertrager für Gleich- und Wechselspannungen mit einer Eingangsschaltung in der die Eingangsspannung in getaktete Ströme umgesetzt und diese über einen Obertrager einer Ausgangsschaltung zugeführt sind, in der die Ströme zur Bildung einer Ausgangsspannung zusammengefaßt sind, dadurch gekennzeichnet, daß die Eingangsschaltung eine nach Art eines Ringmodulators aufgebaute Stufe aufweist, an deren ersten Eingang (1, 2) die Eingangsspannung (U1) angeschlossen ist, deren Ausgang an der Primärwicklung (3) eines Obertragers (4) liegt, dessen getrennte Sekundärwicklung (16) mit einer weiteren - wie in der Eingangsschaltung nach Art eines Ringmodulators geschaltete - zweiten Stufe verbunden ist, jeweils ein zweiter Eingang der beiden Stufen mit einer Taktspannung umgetaktet werden und die Taktspannung ($U_T$), wie der Wicklungssinn der Obertragerwicklungen (3, 16) derart gewählt ist, daß durch die Taktung der zweiten Stufe die Taktung der ersten Stufe rückgängig gemacht wird und am Ausgang (17, 18) der Ausgangsschaltung eine zusammengesetzte Spannung mit gleicher Kurvenform, Polarität und Phasenlage wie die Eingangsspannung anliegt.

IA-Er/78

2. Trennübertrager nach Anspruch 1, dadurch gekennzeichnet, daß die nach Art von Ringmodulatoren geschalteten Stufen mit jeweils vier Transistoren (T1 bis T8), insbesondere Feldeffekttransistoren aufgebaut sind, welche durch die Taktspannung ($U_T$) gesteuert, die am anderen Eingang anliegende Spannung umgepolt weiterleiten.

3. Trennübertrager nach Anspruch 1 oder 2, dadurch gekennzeichnet, daß die Taktung über einen weiteren, magnetisch zum ersten Übertrager (4) entkoppelten zweiten Übertrager (8, 25) für die Taktspannungen der Ein- und Ausgangsstufen aufweist.

4. Trennübertrager nach Anspruch 3, dadurch gekennzeichnet, daß der zweite Übertrager (8) zusätzliche Wicklungen (10, 2o) zur Erzeugung von Versorgungsspannungen für die Ein- und Ausgangsstufen aufweist.

5. Trennübertrager nach einem der Ansprüche 1 oder 3, dadurch gekennzeichnet, daß die Ein- und/oder Ausgangsstufen mit Halbleiterdioden, insbesondere Siliziumdioden (V1 bis V8) aufgebaut sind und die Taktung mit einer Rechteckspannung erfolgt, deren Impulsamplituden größer sind als die Flußspannung der durch diese beaufschlagten Dioden.

6. Trennübertrager nach einem der Ansprüche 1 bis 5, dadurch gekennzeichnet, daß die Frequenz der Taktspannung größer gewählt ist als die maximale Frequenz der zu übertragenden Eingangsspannung.

7. Trennübertrager nach einem der Ansprüche 1 bis 6, dadurch gekennzeichnet, daß die Taktfrequenz eine Hochfrequenz zwischen 20 kHz und 1 MHz ist und als Übertrager (4, 8, 25) Ringkernübertrager mit Ferritkernen gewählt sind.

IA-Er/78

8. Trennübertrager nach einem der Ansprüche 1 bis 7, dadurch gekennzeichnet, daß dieser als Meßwertübertrager für kleine Spannungen dient, und die Eingangsschaltung von der Ausgangsschaltung durch hohe Isolationswiderstände mit großer Durchschlagsfestigkeit galvanisch getrennt ist.

9. Trennübertrager nach Anspruch 8, dadurch gekennzeichnet, daß die Eingangsschaltung galvanisch mit einem Strommeßwiderstand (41) eines Hauptstromkreises und die Ausgangsschaltung galvanisch mit Steuerstromkreisen verbunden ist, die elektronische Betriebsmittel aufweisen.

10. Elektronisch gesteuerter Servomotor (40) mit Strommeßwiderständen (41) in den Hauptstromkreisen (39) und einem Trennübertrager (42) nach einem der Ansprüche 1 bis 9, dadurch gekennzeichnet, daß die Eingangsschaltung des Trennübertragers mit der Primärwicklung eines ersten Obertragers und einer Sekundärwicklung eines Taktspannungsübertragers von den übrigen Wicklungen der Obertrager und der Ausgangsschaltung derart getrennt aufgebaut sind, daß sich eine Durchschlagsfestigkeit von mehreren tausend Volt ergibt.

11. Trennübertrager nach einem der Ansprüche 1 bis 10, dadurch gekennzeichnet, daß der Trennübertrager als vergossener Baustein zur potentialfreien Strommessung ausgebildet ist.

12. Trennübertrager nach einem der Ansprüche 10 oder 11, dadurch gekennzeichnet, daß der Ausgang des Trennübertragers über RC-Siebglieder (43, 44, 48) am Eingang eines Differenzverstärkers (45) liegt, an dessen Ausgang (46), bezogen auf einen Regelkreispegel (47), eine zum Stromistwert proportionale Spannung anliegt.

Fig. 1

Fig. 2

Fig.3

Fig. 4

Fig. 5

Europäisches
Patentamt

**EUROPÄISCHER RECHERCHENBERICHT**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. ³) |
|---|---|---|---|
| X | US-A-4 074 076 (D.R. ZRUDSKY) * Bilder 1,2; Spalte 3, Zeile 21 - Spalte 5, Zeile 52; Spalte 8, Zeilen 40-68; Spalte 9, Zeilen 57-62 * | 1-3 | H 03 F 3/387 |
| | --- | | |
| X | TECHNISCHE MITTEILUNGEN, Band 58, Nr. 6, 1968, Seiten 333-340, Berlin, DE. G. AULICH et al.: "Gleichstromverstärker in Steckkartentechnik" * Bilder 7,9; Seite 338, Kapitel 5, Absätze 5.1 und 5.2 * | 1-3,8, 11 | |
| | --- | | |
| X | ELEKTRONIK, Band 76, Nr. 4, April 1967, Seite 122, München, DE. "Potentialtrennende Messwertumsetzer für Gleichstrom und Gleichspannung" * Seite 122 * | 1-4 | |
| | --- | | RECHERCHIERTE SACHGEBIETE (Int. Cl. ³) |
| A | SIEMENS ZEITSCHRIFT, Band 46, Nr. 4, April 1972, Seiten 227-229, Erlangen, DE. H. SIMA: "Isolierverstärker nach dem FM-PDM-Prinzip für Messungen in Hochspannungskreisen" * Bilder 1,4; Absatz: "Anwendungsgebundene Anforderungen an einen Isolierverstärker" * | 9,10, 12 | H 03 F |
| | --- | | |
| | -/- | | |

Der vorliegende Recherchenbericht wurde für alle Patentansprüche erstellt.

| Recherchenort | Abschlußdatum der Recherche | Prüfer |
|---|---|---|
| DEN HAAG | 17-09-1982 | TYBERGHIEN G.M.P. |

KATEGORIE DER GENANNTEN DOKUMENTEN
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, überein- stimmendes Dokument

EPA Form 1503. 03.82

Europäisches
Patentamt

**EUROPÄISCHER RECHERCHENBERICHT**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. ³) |
|---|---|---|---|
| A | FR-A-1 298 448 (LE TRANSISTOR INDUSTRIEL)<br>* Bild 2; Seite 3, linke Spalte, Zeile 35 - rechte Spalte, Zeile 35 *<br>--- | 5 | |
| A | DE-A-1 238 507 (H.M. DAVIS)<br>* Bilder 3,4; Spalte 4, Zeilen 19-62 * & FR - A - 1 357 572<br>----- | 1,2 | |

RECHERCHIERTE
SACHGEBIETE (Int. Cl. ³)

Der vorliegende Recherchenbericht wurde für alle Patentansprüche erstellt.

| Recherchenort | Abschlußdatum der Recherche | Prüfer |
|---|---|---|
| DEN HAAG | 17-09-1982 | TYBERGHIEN G.M.P. |